# EUROPEAN PATENT SPECIFICATION

(11) **EP 0 597 717 B1**
(45) Date of publication and mention of the grant of the patent: **20.02.2002**
(21) Application number: 93309038.3
(22) Date of filing: 11.11.1993
(51) Int. Cl.: G01R 27/02, G01R 31/02

(54) **Apparatus for measuring a resistance of a high tension resistance electrical cable**
Einrichtung zur Messung eines Widerstandes einer elektrischen Hochspannungs-Widerstandsleitung
Dispositif de mesure d'une résistance d'un câble haute-tension électriquement résistant

(30) Priority: 12.11.1992 JP 8467792 U
(43) Date of publication of application: 18.05.1994
(73) Proprietor: Sumitomo Wiring Systems, Ltd., Yokkaichi-shi Mie-ken (JP)
(72) Inventor: Murakami, Yukio, c/o Sumitomo Wiring Systems, Ltd., Yokkaichi-shi, Mie-ken (JP); Watanabe, Yuji, c/o Sumitomo Wiring Systems, Ltd., Yokkaichi-shi, Mie-ken (JP)
(74) Representative: Spall, Christopher John

(56) References cited:
- EP-A- 0 168 346
- DD-A- 124 846
- DE-C- 3 843 877
- US-A- 4 004 843
- US-A- 4 843 313
- PATENT ABSTRACTS OF JAPAN vol. 14, no. 547 (P-1138) 5 December 1990 & JP-A-02 232 569 (SUMITOMO)

## Description

This invention relates to an apparatus for measuring a resistance of a high tension resistance electrical cable to be used in an ignition cable or the like for an automobile or the like.

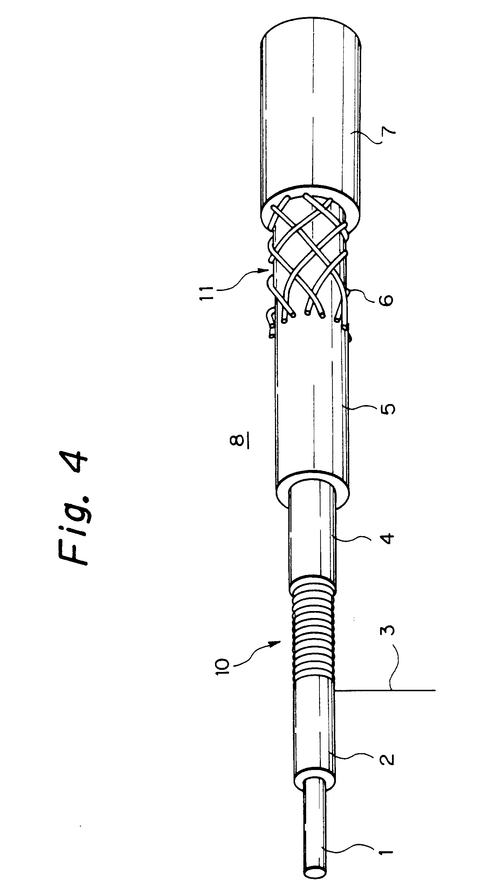

Heretofore, there has been known a coil type high tension resistance electrical cable as an ignition cable to be used in an ignition circuit of an automobile engine. For convenience of explanation, a conventional typical coil type high tension resistance electrical cable will be described with reference to FIG. 4. FIG. 4 is a perspective view illustrating a prior high tension resistance electrical cable 8 a part of which is exposed. As shown in FIG. 8, the high tension resistance electrical cable 8 comprises a strand like fiber 1 such as a glass fiber, polyamid fiber, etc., a coil core layer 2 which covers the strand like fiber with a synthetic resin such as a silicone resin or the like, a resistance wire 3 made of a metal wire such as a nickel-chromium resistance wire or the like which is spirally wound around the coil core layer 2 in its longitudinal direction, a conductive silicone rubber layer 4 which covers the resistance wire 3, an insulation layer 5 made of a synthetic rubber or the like which covers the layer 4, a net 6 made of a glass fiber which is provided on the outer face of the insulation layer 5, and a sheath layer 7 made of a silicone rubber or the like which covers the net 6 (see Japanese Patent Public Disclosure No. 60-3809 (1985)).

A resistance conductor 10 is constituted of the strand like fiber 1, coil core layer 2, resistance wire and conductive silicone rubber layer 4 while a sheath outer layer 11 which covers the resistance conductor 10 is constituted of the insulation layer 5, net 6, and sheath layer 7.

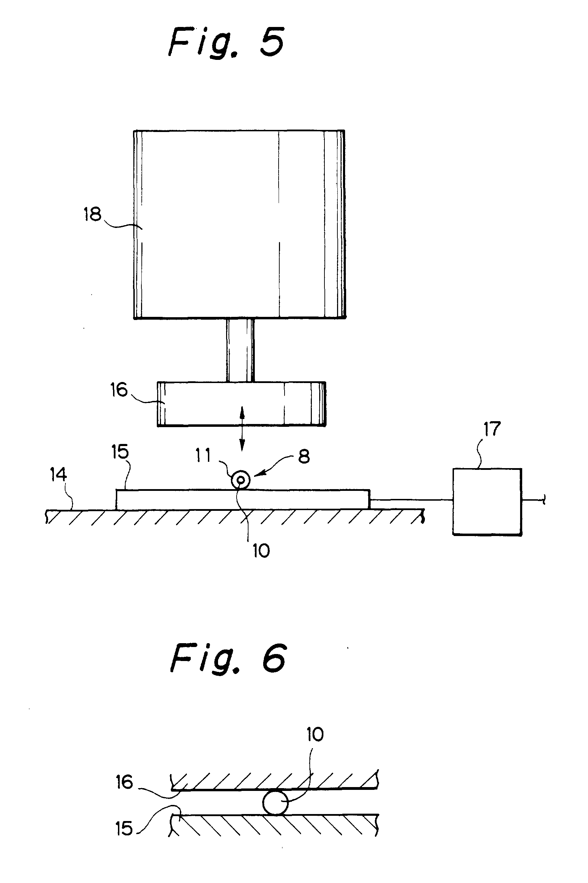

For convenience of explanation, examination of whether the high tension resistance electrical cable 8 has a predetermined resistance suitable for use as an ignition cable is described below with reference to FIGS. 5 and 6.

FIG. 5 is a front side elevation view of a prior resistance-measuring apparatus and FIG. 6 is a partially enlarged view of the apparatus shown in FIG. 5, which shows another operating position.

The resistance examination of the high tension resistance electrical cable 8 comprises the steps of: cutting the cable 8 fed successively from a stock drum or the like into a given length; stripping the sheath outer layer 11 from the cable 8 at the opposite ends; electrically connecting the exposed resistance conductor 10 to the resistance-measuring apparatus at the opposite ends; and measuring a resistance of the cable 8.

The resistance-measuring apparatus, as shown in FIG. 5, comprises a bed 14, a stationary copper plate 15 fixed on the bed 14 for contacting with the resistance conductor 10, a movable copper plate 16 attached to a raising and lowering means 18 above the stationary copper plate 15 for contacting with the resistance conductor 10, and a resistance meter 17 electrically connected to the stationary copper plates 15 (one of them is not shown in FIG. 5).

The raising and lowering means 18 is an air cylinder or the like, which is supported on the bed and raises and lowers the movable copper plate 16 within a given range through a buffer mechanism not shown.

When exposed resistance conductor 10 is guided at a given position between the stationary copper plate 15 and the movable copper plate 16, the air cylinder 18 is actuated to lower the movable copper plate 16, the resistance conductor 10 is clamped between the plates 15 and 16. Then, the pair of stationary copper plates 15 are electrically connected to each other through the resistance conductor 10 and thus the resistance meter 17 measures the resistance of the resistance conductor 10.

However, according to the prior resistance-measuring apparatus, since the copper plates 15 and 16 clamp the resistance conductor 10 to contact with it, the resistance conductor 10 may be crushed by the plates 15 and 16. Accordingly, a contacting force onto the conductor 10 by the plates 15 and 16 is adjusted to be slight.

Consequently, as shown in FIG. 6, a contacting area between the resistance conductor 10 and the copper plates 15, 16 becomes a line, thereby making a contact state therebetween unstable. This results in a dispersion of ±2KΩ in a measured resistance value, thereby lowering a reliability of goods.

An apparatus according to the preamble of claim 1 is known from Patent Abstracts of Japan, vol. 14, no.547 (P-1138)(JP 0 232 569 A).

An object of the present invention is to provide a resistance-measuring apparatus for a high tension resistance electrical cable, which prevents a measured value of resistance from being dispersed.

In order to achieve the above object, an apparatus for measuring a resistance of a high tension resistance electrical cable is provided as defined in claim 1.

According to the present invention, the elastic contact pieces contact with the resistance conductor in their resilient deformation when they clamp the resistance conductor at its opposite sides, a contact area therebetween becomes a curved plate, thereby settling their contact position and effectively preventing a measured value of resistance from being dispersed.

Also, since the elastic contact pieces are elastically deformed when they are pressed to the resistance conductor at its opposite sides, the resistance conductor is prevented from being crushed.
FIG. 1 is an explanatory view of a main part of an embodiment of a resistance-measuring apparatus for a high tension resistance electrical cable in accordance with the present invention;
FIG. 2 is a cross sectional view of a part of contact pieces, illustrating a pressing position of the pieces;
FIG. 3 is a schematic view illustrating processes of treating the high tension resistance electrical cable;
FIG. 4 is a perspective view of a prior high tension resistance electrical cable;
FIG. 5 is a schematic side elevation view of a prior resistance-measuring apparatus for the cable; and
FIG. 6 is a cross sectional view of contact pieces illustrating a contacting position of the pieces.

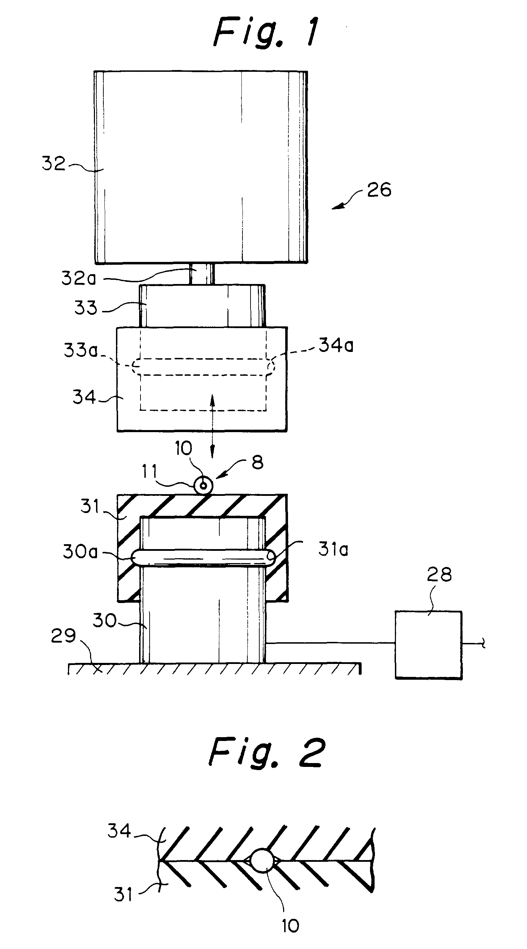

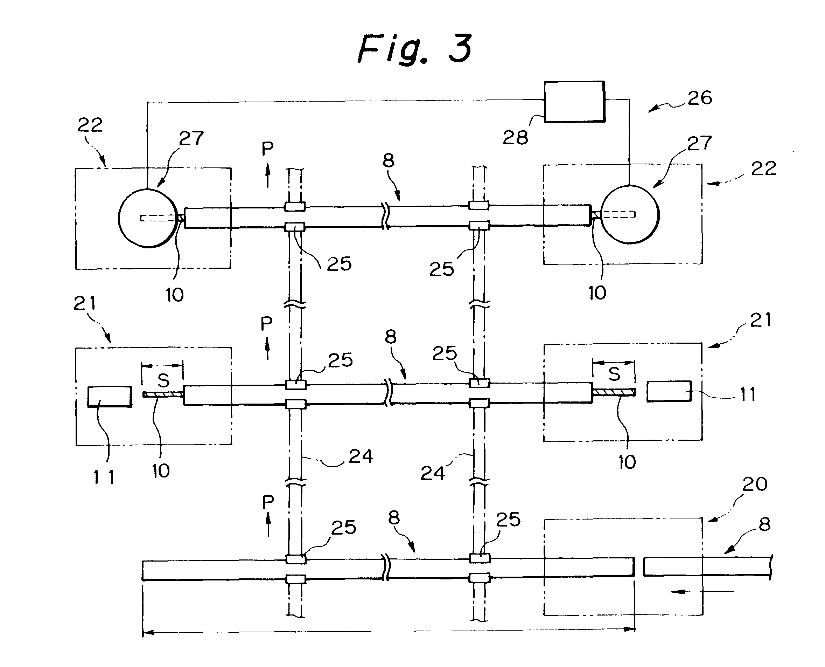

Referring now to FIGS. 1 to 3, an embodiment of a resistance-measuring apparatus for a high tension resistance electrical cable, in accordance with the present invention, will be described below. FIG. 3 shows a schematic treating process of the coil type high tension resistance electrical cable 8 constructed by the same manner described above to be used in the automobile. The apparatus includes a cable cutting station 20 which cuts the high tension resistance electrical cable 8 fed successively from a stock drum not shown in a given length L, a stripping station 21 which stripes a sheath of the cable 8 at its opposite ends to expose the resistance conductor 10 by a given length S, and a resistance-measuring station 22 which measures a resistance of the cable 8.

In FIG. 3, conveyors 24 such as endless chains or belts are intermittently driven and circulated. The conveyors 24 are provided with a plurality of clamps 25 spaced at a given distance in the longitudinal direction of the conveyor and actuated to open and close.

The high tension resistance electrical cable 8 cut into the given length L at the cable cutting station 20 is clamped at opposite ends by the clamps 25 and fed in a feeding direction P of the conveyor 24 to the stripping station 21 and resistance measuring station 22.

At the stripping station 21, a stripping device not shown strips the sheath outer layer 11 of the cable 8 at its opposite ends to expose the resistance conductor 10 by the given length S.

Hereafter, the cable 8 is fed to the resistance-measuring station 22 and the resistance of the cable 8 is measured by a resistance-measuring apparatus 26 arranged at the station 22.

The resistance-measuring apparatus 26 is provided with conductor-contacting mechanisms 27 disposed at a position where the stripped resistance conductor 10 of the cable 8 pass through, and a resistance meter 28 electrically connected to the conductor-contacting mechanisms 27.

As shown in FIG. 1, each conductor-contacting mechanism 27 includes a cylindrical conductive copper block 30 fixed on a bed 29, an elastic contact piece 31 mounted on an upper portion of the conductive copper block 30 for contacting with the conductor 10, a raising and lowering cylinder 32 such as an air cylinder secured to the bed 29 above the block 30, a cylindrical conductive copper block 33 secured to a distal end of a piston rod 32a which extends downwardly from the raising and lowering cylinder 32, and an elastic contact piece 34 mounted on a lower portion of the block 33.

Each of the elastic contact pieces 31 and 34 is made of a conductive elastic material such as conductive silicone rubber or the like and formed into a cylinder shape with a bottom wall. The respective contact pieces 31 and 34 are closely mated with the respective copper blocks 30 and 33. The blocks 30 and 33 are provided on their outer faces with annular projections 30a and 33a while the elastic contact pieces 31 and 34 are provided on their interiors with annular grooves 31a and 34a associated with the annular projections 30a and 33a. The pieces 31 and 34 are coupled with the blocks 30 and 33 so that the projections 30a and 33a engage with the groves 31a and 34a, thereby preventing the pieces 31 and 34 from falling out of the blocks 30 and 33.

When the cylinder 32 advances and retracts the piston rod 32a, the upper elastic contact piece 34 is moved down and up between an examination position where the upper piece 34 contacts with and presses the lower contact piece 31 and a stand-by position where the upper contact piece 34 is spaced away from the lower contact piece 31.

The resistance meter 28 is electrically connected to each conductive copper block 30 of each conductor-contacting mechanism 27.

As shown in FIGS. 1 and 3, the resistance-measuring apparatus 26 measures the resistance of the cable 8 by lowering the elastic contact piece 34 to the examination position by the cylinder 32 when the exposed resistance conductor 10 is fed to the given position between the elastic contact pieces 31 and 34, and by press-contacting the piece 31 with the piece 34 to clamp the conductor 10 therebetween. At this time, the resistance conductor 10 is press-contacted with the contact pieces 31 and 34, thereby electrically connecting the conductor 10 through the piece 31 to the copper block 30. Consequently, the resistance meter 28 can measure the resistance of the resistance conductor 10.

After measuring the resistance, the cylinder 32 raises the elastic contact piece 34 to the stand-by position and the cable 8 is removed from the apparatus as faulty goods if the conductor 10 has not a given resistance.

In the above embodiment, since the elastic contact pieces 31 and 34 which are press-contacted with the resistance conductor 10 at its opposite sides are made of an elastic material, the pieces 31 and 34 are contacted with the conductor 10 in the elastic deformation when the upper contact piece 34 is lowered and contacted with the lower contact piece 31. Consequently, the contact area between the contact pieces 31, 34 and the resistance conductor 10 becomes a wide curved plane, thereby settling the contact position, minimizing the dispersion of resistance (±0.1KΩ) and enhancing a reliability of goods. Further, the resistance conductor 10 is not crushed by the pieces 31 and 34 since the pieces are elastically deformed upon press-contacting.

According to the apparatus for measuring the electrical resistance of a high tension resistance electrical cable of the present invention, since the conductive contact pieces are made of the conductive elastic material, the elastic contact pieces clamp the resistance conductor in the elastic deformation at its opposite sides, thereby increasing the contact area, stabilizing the contact position, and minimizing a dispersion of the measured resistance value.

In addition, the resistance conductor is not crushed by the contact pieces when they clamp the conductor, since the pieces are resiliently deformed.

## Claims

1. An apparatus for measuring the electrical resistance of a high tension resistance cable (8), wherein said cable (8) comprises a resistance conductor (10) including a strand like fiber (1), a coil core layer (2) which covers an outer peripheral surface of said strand like fiber (1), and a resistance wire (3) which is spirally wound around said coil core layer (2), and a sheath outer layer (11) which covers an outer peripheral portion of said resistance conductor (10), wherein said cable is cut off by a given length and said sheath outer layer (11) is stripped off at the opposite ends of said cable to expose said resistance conductor (10); wherein the apparatus includes a pair of conductive contact pieces (31,34), which can be brought into contact with said resistance conductor (10) at opposite sides thereof to measure the resistance of said cable (8);
**characterized in that**:
said conductive contact pieces are elastic contact pieces (31, 34) having a cylinder shape and a bottom wall and made of a conductive elastic material;
wherein each of said elastic contact pieces (31, 34) is closely mounted on a respective conductive copper block (30, 33) by fitting engagement of annular projections (30a, 33a) on said conductor copper blocks (30, 33) with annular grooves (31a, 34a) provided on interiors of said elastic contact pieces (31, 34) to prevent said elastic contact pieces from falling out of said blocks;
wherein, in use, said elastic contact pieces (31, 34) clamp and press said resistance conductor (10) at the opposite sides thereof upon measuring the resistance of the cable whilst pressing the outer peripheral surface of said resistance conductor (10).

## Patentansprüche

1. Eine Einrichtung zum Messen des elektrischen Widerstands eines Hochspannungswiderstandskabels (8), wobei das Kabel (8) umfasst: einen Widerstandsleiter (10) einschließlich einer einzeldrahtähnlichen Faser (1), eine Spulenkernschicht (2), die eine äußere Umfangsoberfläche der einzeldrahtähnlichen Faser (1) bedeckt, und einen Widerstandsdraht (3), der spiralförmig um die Spulenkernschicht (2) gewickelt ist, und eine äußere Mantelschicht (7), die einen äußeren Umfangsabschnitt des Widerstandsleiters (10) bedeckt, wobei das Kabel auf eine gegebene Länge zugeschnitten wird und die äußere Mantelschicht (11) an den gegenüberliegenden Enden des Kabels abgezogen wird, um den Widerstandsleiter (10) freizulegen; wobei die Einrichtung ein Paar von leitenden Kontaktteilen (31, 34) umfasst, die in Kontakt mit dem Widerstandsleiter (10) an gegenüberliegenden Seiten desselben gebracht werden können, um den Widerstand des Kabels (8) zu messen;
**dadurch gekennzeichnet, dass** die leitenden Kontaktteile elastische Kontaktteile (31, 34) sind, die eine Zylinderform und eine Bodenwand aufweisen und aus einem leitenden, elastischen Material hergestellt sind;
wobei jedes der elastischen Kontaktteile (31, 34) eng an einem entsprechenden leitenden Kupferblock (30, 33) durch einen Passeingriff der ringförmigen Vorsprünge (30a, 31a) auf den Leiterkupferblöcken (30, 33) mit ringförmigen Nuten (31a, 34a), die auf der Innenseite der elastischen Kontaktteile (31, 34) vorgesehen sind, befestigt ist, um zu verhindern, dass die elastischen Kontaktteile aus den Blöcken herausfallen;
und wobei während des Gebrauchs die elastischen Kontaktteile den Widerstandsleiter (10) an den gegenüberliegenden Seiten desselben bei der Messung des Widerstandes des Kabels einklemmen und drücken, während die äußere Umfangsoberfläche des Widerstandsleiters (10) gedrückt ist.

## Revendications

1. Appareil pour mesurer la résistance électrique d'un câble de résistance haute tension (8), où ledit câble (8) comprend un conducteur de résistance (10) incluant une fibre semblable à un écheveau (1), une couche d'âme de bobine (2) qui couvre une surface périphérique extérieure de ladite fibre (1) semblable à un écheveau, et un fil de résistance (3) qui est enroulé en spirale autour de ladite couche d'âme de bobine (2), et une couche externe de gaine (11) qui couvre une portion périphérique externe dudit conducteur de résistance (10), où ledit câble est coupé en une longueur donnée et ladite couche externe de gaine (11) est retirée aux extrémités opposées dudit câble pour exposer ledit conducteur de résistance (10) ; où l'appareil comprend une paire de pièces de contact conductrices (31, 34) qui peuvent être amenées en contact avec ledit conducteur de résistance (10) aux côtés opposés de celui-ci pour mesurer la résistance dudit câble (8) ;
**caractérisé en ce que** lesdites pièces de contact conductrices sont des pièces de contact élastiques (31, 34) ayant une forme cylindrique et une paroi de fond et sont réalisées en un matériau élastique conducteur ; où chacune desdites pièces de contact élastiques (31, 34) est montée étroitement sur un bloc de cuivre conducteur respectif (30, 33) par un engagement adapté des saillies annulaires (30a, 33a), sur lesdits blocs de cuivre conducteurs (30, 33) avec des rainures annulaires (31a, 34a) prévues sur les intérieurs desdites pièces de contact élastiques (31, 34) pour empêcher que lesdites pièces de contact élastiques tombent desdits blocs ; où en cours d'utilisation, lesdites pièces de contact élastiques (31, 34) serrent et exercent une pression sur ledit conducteur de résistance (10) aux côtés opposés de celui-ci lors de la mesure de la résistance du câble tout en exerçant une pression sur la surface périphérique extérieure dudit conducteur de résistance (10).
